# DEMANDE DE BREVET EUROPEEN

(11) **EP 1 152 457 A1**
(43) Date de publication de la demande: **07.11.2001**
(21) Numéro de dépôt: 01400998.9
(22) Date de dépôt: 19.04.2001
(51) Int. Cl.: H01L 21/00

(54) **Procédé et dispositif pour le traitement d'un substrat**

(30) Priorité: 20.04.2000 FR 0005087
(71) Demandeur: Karl Suss France, 74490 St. Jeoire en Faucigny (FR)
(72) Inventeur: Cavazza, Gilbert, 74250 Viuz en Sallaz (FR)
(74) Mandataire: Bonnetat, Christian

(57) **Abrégé**

- Procédé et dispositif pour le traitement du substrat d'un circuit intégré ou d'un produit analogue en cours de fabrication.
- Selon l'invention, on pulvérise, de bas en haut, un liquide de traitement (24) sur la face à traiter (20I), dirigée vers le bas, dudit substrat (20) et des transducteurs (8) appliquent des ondes ultrasonores audit substrat (20) par l'intermédiaire dudit liquide de traitement pulvérisé (24).

## Description

La présente invention concerne un procédé et un dispositif pour le traitement du substrat d'un circuit intégré ou produit analogue en cours de fabrication, ledit traitement ayant au moins pour objet d'éliminer, grâce à l'action d'au moins un liquide de traitement, des particules indésirables portées par une face à traiter dudit substrat.

De telles particules indésirables peuvent être des poussières ou analogues, ou bien des portions de résine photosensible non durcies à la suite d'une exposition du substrat à travers un masque. En conséquence, ledit liquide de traitement peut être un liquide de lavage ou de rinçage (par exemple de l'eau) ou bien un liquide de développement de ladite résine.

On connaît déjà de nombreux procédés et dispositifs pour un tel traitement. Parmi ces procédés et dispositifs connus, ceux décrits par le document US-4 655 162 proposent de maintenir ledit substrat, pendant ledit traitement, de façon que sa surface à traiter soit dirigée vers le bas. Il en résulte alors l'avantage que lesdites particules indésirables sont facilement éliminées, car elles sont soumises à l'action de la pesanteur, en plus de l'action d'entraînement dudit liquide de traitement. Dans ce document antérieur, ledit liquide de traitement est contenu dans une coupelle, qui est disposée sous ledit substrat, et dans laquelle peut être introduit ce dernier.

La présente invention a pour objet un procédé et un dispositif de ce type, dans lesquels l'élimination desdites particules indésirables est encore améliorée.

A cette fin, selon l'invention, le procédé pour le traitement du substrat d'un circuit intégré ou produit analogue en cours de fabrication, ledit traitement ayant au moins pour objet d'éliminer, grâce à l'action d'au moins un liquide de traitement, des particules indésirables portées par une face à traiter dudit substrat et ledit substrat étant maintenu, pendant ledit traitement, de façon que ladite face à traiter soit dirigée vers le bas, est remarquable :
- en ce qu'on pulvérise, de bas en haut, ledit liquide de traitement sur ladite face à traiter ; et
- en ce qu'on applique des ondes ultrasonores audit liquide de traitement, qui transmet lesdites ondes jusqu'audit substrat.

Ainsi, grâce à un tel mode opératoire, lesdites particules indésirables sont complètement décollées de ladite face à traiter par les ultrasons, avant d'être éliminées par l'action conjuguée de l'entraînement du liquide et de l'attraction de la pesanteur. Il en résulte une élimination particulièrement efficace, puisque, grâce aux ultrasons, aucune particule ne peut rester accrochée suffisamment fortement à ladite face à traiter pour résister au liquide et à la pesanteur.

Selon une première forme de mise en oeuvre, ledit liquide de traitement pulvérisé forme une pluralité de jets individuels, transmettant lesdites ondes ultrasonores audit substrat. En variante, ledit liquide de traitement pulvérisé peut former une couche liquide qui recouvre ladite face à traiter et qui transmet les ondes ultrasonores audit substrat.

Pendant ledit traitement, ledit substrat pourrait être immobile. Toutefois, il est souvent préférable qu'il soit alors animé d'un mouvement de rotation autour d'un axe vertical. Un tel mouvement de rotation peut être continu ou alternatif.

Pour la mise en oeuvre d'un tel procédé, la présente invention concerne de plus un dispositif remarquable en ce qu'il comporte :
- des moyens pour maintenir ledit substrat de façon que ladite face à traiter soit dirigée vers le bas ;
- un plan de travail dirigé vers le haut et disposé sous ledit substrat, en regard de celui-ci ;
- des moyens de pulvérisation du liquide de traitement, mécaniquement liés audit plan de travail ; et
- au moins un transducteur à ultrasons, mécaniquement lié audit plan de travail.

De préférence, ledit plan de travail repose sur un réservoir pour un liquide thermiquement conducteur et ledit transducteur à ultrasons est fixé sur ledit réservoir. Ledit liquide thermiquement conducteur, qui peut circuler à travers ledit réservoir, permet ainsi d'absorber et d'éliminer la chaleur dégagée par ledit transducteur.

Par ailleurs, il est avantageux que lesdits moyens de pulvérisation du liquide de traitement soient en contact thermique avec ledit liquide thermiquement conducteur du réservoir. Ainsi, par échange thermique avec ce dernier, ledit liquide de traitement pulvérisé peut être porté à une température de fonctionnement appropriée. Bien entendu, à cet effet, on peut prévoir une source auxiliaire de chauffage dudit liquide du réservoir, dans le cas où la chaleur apportée par le transducteur à ultrasons ne serait pas suffisante pour atteindre cette température de fonctionnement du liquide de traitement.

Pour évacuer ledit liquide de traitement pulvérisé après son impact sur ladite face à traiter, il est avantageux de prévoir une rigole d'évacuation à la périphérie dudit plan de travail. A cette rigole peut être associé un déflecteur annulaire entourant ledit plan de travail et en saillie vers le haut par rapport à celui-ci, destiné à diriger les projections dudit liquide de traitement vers ladite rigole. Un tel déflecteur est particulièrement avantageux lorsque ledit substrat tourne pendant la pulvérisation et que du liquide de traitement est éjecté à la périphérie dudit substrat. On remarquera que ledit plan de travail et ledit déflecteur annulaire en saillie forment une sorte de cuvette à l'intérieur de laquelle peut être au moins partiellement disposé ledit substrat lors de la pulvérisation. Dans le cas où, dans cette cuvette, le substrat est relativement éloigné du plan de travail, les jets de pulvérisation de liquide restent individuels. En revanche, si le substrat est relativement proche du plan de travail, lesdits jets peuvent former, par effet de tension superficielle, une couche liquide recouvrant et rejoignant ledit plan de travail et ladite face à traiter du substrat.

De préférence, lesdits moyens de maintien dudit substrat sont mobiles de façon à pouvoir être écartés dudit plan de travail, par exemple pour permettre le brossage ou le séchage par soufflage d'un gaz, aussi bien du plan de travail que de ladite face à traiter du substrat.

Pour les même raisons, il est avantageux que ledit déflecteur soit également monté mobile de façon à pouvoir être écarté dudit plan de travail.

Les figures du dessin annexé feront bien comprendre comment l'invention peut être réalisée. Sur ces figures, des références identiques désignent des éléments semblables.

La figure 1 est une vue en élévation schématique, partiellement en coupe, d'un exemple de réalisation du dispositif conforme à la présente invention.

La figure 2 illustre schématiquement, à l'aide d'une vue partielle à plus petite échelle de la figure 1, un mode de mise en oeuvre du dispositif selon la présente invention.

La figure 3 illustre schématiquement, en vue semblable à la figure 2, une variante de mise en oeuvre du dispositif conforme à la présente invention.

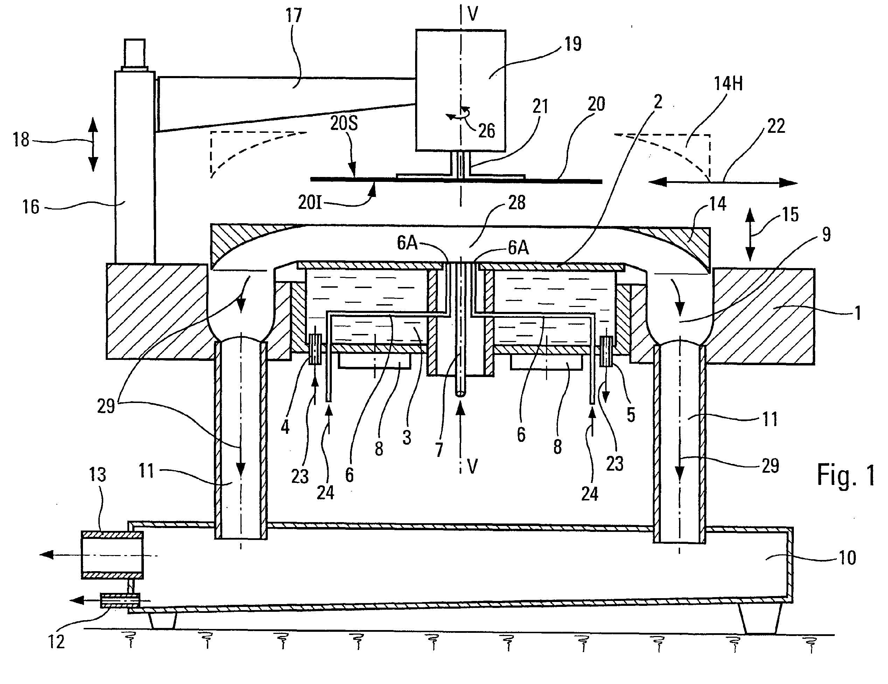

Le dispositif de traitement de substrats de circuits intégrés ou de produits analogues, conforme à la présente invention et montré schématiquement sur la figure 1, comporte un bâti 1 sur lequel est agencé un plan de travail 2 dirigé vers le haut. Le plan de travail 2 repose sur un réservoir 3, pourvu d'une entrée 4 et d'une sortie 5 pour un liquide thermiquement conducteur et porté par le bâti 1. Des conduits 6 traversent ledit réservoir 3 pour être en contact thermique avec le liquide circulant dans ce dernier et débouchent vers le haut par des orifices de sortie 6A au niveau dudit plan de travail 2. Les conduits 6 sont alimentés en liquide de traitement pour substrat de circuits intégrés de toute façon connue et non représentée. De plus, le bâti 1 porte une tubulure 7 dirigée vers le haut et alimentée en liquide de rinçage, par exemple de l'eau. Sur une paroi du réservoir 3 sont fixés des transducteurs à ultrasons 8.

Autour du plan de travail 2, le bâti 1 comporte une rigole périphérique 9, apte à recueillir des liquides, pour les conduire dans un réservoir de stockage 10 disposé sous ledit plan de travail 2, grâce à des conduites verticales 11. Le réservoir de stockage 10 comporte une sortie 12 pour liquides et une sortie 13 pour les gaz, engendrés par lesdits liquides.

Sur le bâti 1, autour du plan de travail 2, est monté un déflecteur annulaire 14, apte à défléchir les projections de liquides de traitement vers la rigole 9. Comme l'indique schématiquement la double flèche 15, le déflecteur annulaire 14 est mobile en hauteur pour pouvoir se rapprocher et s'éloigner du bâti 1. Sur la figure 1, on a représenté en trait plein la position basse dudit déflecteur et en traits mixtes la position haute 14H dudit déflecteur 14.

Dans sa position basse, le déflecteur 14 forme avec le plan de travail 2, une sorte de cuvette 28 ouverte vers le haut. Par ailleurs, une colonne verticale 16 est montée sur le bâti 1, ladite colonne portant un bras 17 en porte-à-faux. Grâce à des moyens connus et non représentés, le bras 17 peut se déplacer parallèlement à lui-même le long de la colonne 16, comme cela est symbolisé par la double flèche 18.

A son extrémité libre, opposée à la colonne 16, le bras 17 porte un dispositif 19 de maintien par succion d'un substrat 20 de circuit intégré. Le dispositif 19 maintient, par l'intermédiaire d'une ventouse 21, le substrat 20 par sa face supérieure 20S, de façon que la face inférieure 20I à traiter soit dirigée vers le bas, en regard du plan de travail 2. La ventouse 21 peut de plus tourner autour de son axe vertical V.V, de sorte que le substrat 20 peut lui-même tourner autour de cet axe.

Lorsque, comme cela est représenté sur la figure 1, le bras 17 est en position haute et que le déflecteur 14 est en position basse, le dispositif de la figure 1 peut être chargé en substrat 20 par un automate de chargement et de déchargement, non représenté, mais symbolisé par la double flèche 22. Après chargement, comme cela est représenté sur la figure 1, le substrat 20 est centré autour de l'axe vertical V.V et est maintenu par la ventouse 21, de façon que sa face 20I à traiter soit dirigée vers le bas, en regard du plan de travail 2. Le substrat 20 peut être entraîné en rotation autour de l'axe vertical V-V, soit de façon continue, soit de façon alternative, comme indiqué par la double flèche 26.

Un liquide de contrôle thermique, symbolisé par les flèches 23, est amené à circuler dans le réservoir 3, entre l'entrée 4 et la sortie 5, et lorsque les transducteurs à ultrasons 8 fonctionnent, un liquide de traitement, symbolisé par les flèches 24, est amené à circuler dans les conduits 6, en échange thermique avec le liquide de contrôle thermique 23. A l'entrée 4 du réservoir 3, la température du liquide de contrôle thermique 23 est choisie de façon que, compte tenu de l'apport de chaleur des transducteurs 8 en fonctionnement et de l'échange de chaleur entre le liquide 23 et le liquide de traitement 24, ce dernier présente la température désirée aux orifices de sortie 6A.

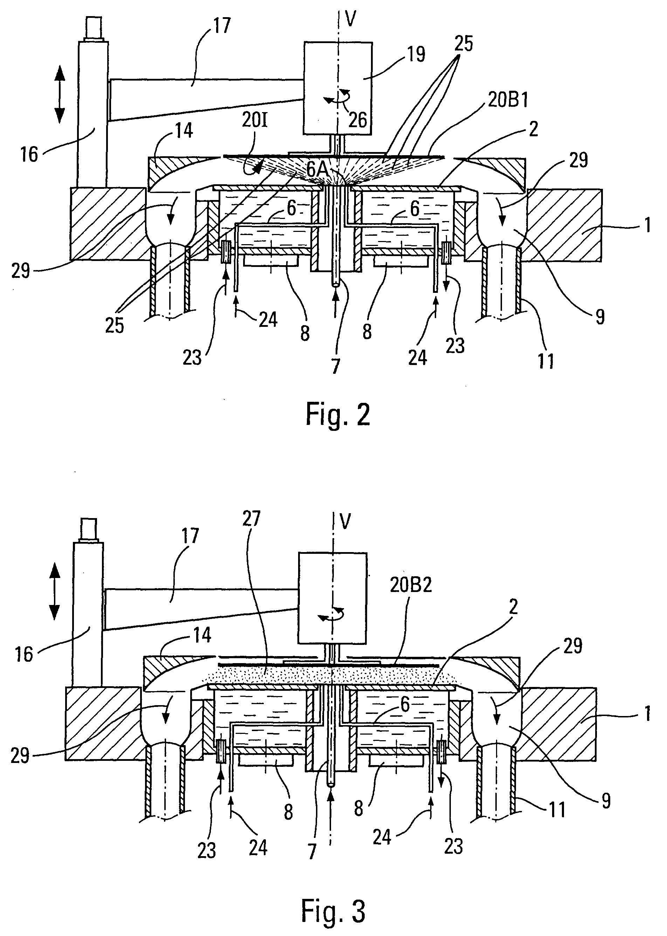

La face à traiter 20I du substrat 20 étant rapprochée du plan de travail 2 et des orifices de sortie 6A par abaissement du bras 17 (pour prendre la position basse 20B1 de la figure 2 proche de l'ouverture de la cuvette 28), ces derniers orifices adressent à ladite face 20I à traiter des jets 25 du liquide 24 (voir la figure 2). Les vibrations ultrasonores engendrées par les transducteurs 8 sont transmises au substrat 20 à travers le réservoir 3, le liquide 23, les conduits 6 et les jets 25. Par suite, les particules indésirables portées par la face 20I du substrat 20 sont décrochées par lesdites ondes ultrasonores et éliminées par le liquide pulvérisé 24 et par gravité. Le liquide 24 pulvérisé sur la face 20I est éliminé par la rigole 9 et les conduits 11 en entraînant lesdites particules (flèches 29).

Si le substrat 20 est abaissé par le bras 17 pour prendre la position basse 20B2 montrée par la figure 3 (en position 20B2, le substrat 20 est introduit dans la cuvette 28 et est plus proche du plan de travail 2 que dans la position 20B1 de la figure 2), les jets individuels 25 peuvent s'agglomérer en une couche liquide mobile 27, emprisonnée entre le substrat 20 et le plan de travail 2 et s'écoulant dans la rigole 9 et dans les conduits 11 (flèches 29).

Bien entendu, de façon semblable à ce qui a été dit ci-dessus, les ondes ultrasonores engendrées par les transducteurs 8 sont transmises à la face 20I du substrat 20 à travers la couche 27, de sorte que les particules indésirables portées par la face 20I du substrat 20 en sont décrochées et éliminées.

On comprendra aisément qu'en position haute du substrat 20 et du déflecteur 14 (position 14H), il est possible d'effectuer des opérations de brossage et/ou de soufflage du plan de travail 2 et/ou de ladite face 20I.

Après pulvérisation du liquide de traitement 24, la face 20I du substrat 20 peut être rincée à l'aide du liquide de rinçage projeté par la tubulure 7.

## Revendications

1. Procédé pour le traitement du substrat (20) d'un circuit intégré ou produit analogue en cours de fabrication, ledit traitement ayant au moins pour objet d'éliminer, grâce à l'action d'au moins un liquide de traitement (24), des particules indésirables portées par une face à traiter (20I) dudit substrat (20) et ledit substrat étant maintenu, pendant ledit traitement, de façon que ladite face à traiter (20I) soit dirigée vers le bas,
**caractérisé :**
- **en ce qu'**on pulvérise, de bas en haut, ledit liquide de traitement (24) sur ladite face à traiter (20I) ; et
- **en ce qu'**on applique des ondes ultrasonores audit liquide de traitement (24), qui transmet lesdites ondes jusqu'audit substrat (20).

2. Procédé selon la revendication 1,
**caractérisé en ce que** ledit liquide de traitement pulvérisé (24) forme une pluralité de jets individuels (25) dirigés vers le haut et transmettant lesdites ondes ultrasonores audit substrat (20).

3. Procédé selon la revendication 1,
**caractérisé en ce que** ledit liquide de traitement pulvérisé (24) forme une couche liquide (27) qui recouvre ladite face à traiter (20I) et qui transmet lesdites ondes ultrasonores audit substrat (20).

4. Procédé selon l'une des revendications 1 à 3,
**caractérisé en ce que** ledit substrat (20) est animé d'un mouvement de rotation autour d'un axe vertical (V-V) pendant ledit traitement.

5. Dispositif pour la mise en oeuvre du procédé spécifié sous l'une quelconque des revendications 1 à 4,
**caractérisé en ce qu'**il comporte :
- des moyens (19, 21) pour maintenir ledit substrat (20) de façon que ladite face à traiter (20I) soit dirigée vers le bas ;
- un plan de travail (2) dirigé vers le haut et disposé sous ledit substrat (20), en regard de celui-ci ;
- des moyens (6) de pulvérisation du liquide de traitement (24), mécaniquement liés audit plan de travail (2) ; et
- au moins un transducteur à ultrasons (8), mécaniquement lié audit plan de travail (2).

6. Dispositif selon la revendication 5,
**caractérisé en ce que** ledit plan de travail (2) repose sur un réservoir (3) pour un liquide thermiquement conducteur (23) et **en ce que** ledit transducteur à ultrasons (8) est fixé sur ledit réservoir (3).

7. Dispositif selon la revendication 6,
**caractérisé en ce que** ledit liquide thermiquement conducteur (23) circule à travers ledit réservoir (3).

8. Dispositif selon l'une des revendications 6 ou 7,
**caractérisé en ce que** lesdits moyens (6) de pulvérisation du liquide de traitement (24) sont en contact thermique avec ledit liquide thermiquement conducteur (23).

9. Dispositif selon l'une des revendications 5 à 8,
**caractérisé en ce que** lesdits moyens de maintien (19, 21) du substrat (20) sont mobiles pour pouvoir être écartés dudit plan de travail (2).

10. Dispositif selon l'une des revendications 5 à 9,
**caractérisé en ce qu'**il comporte une rigole d'évacuation (9) à la périphérie du plan de travail (2).

11. Dispositif selon la revendication 10,
**caractérisé en ce qu'**il comporte un déflecteur annulaire (14) entourant ledit plan de travail (2) et en saillie vers le haut par rapport à ce dernier.

12. Dispositif selon la revendication 11,
**caractérisé en ce que** ledit déflecteur annulaire (14) est monté mobile de façon à pouvoir être écarté dudit plan de travail (2).
